# EUROPÄISCHE PATENTSCHRIFT

(11) **EP 2 997 609 B1**
(45) Veröffentlichungstag und Bekanntmachung des Hinweises auf die Patenterteilung: **19.06.2019**
(21) Anmeldenummer: 14721350.8
(22) Anmeldetag: 30.04.2014
(51) Int. Cl.: H05B 33/14, H01L 33/50, H01L 25/075

(54) **WEISSLICHT-LED-MODUL ZUR OBJEKTBELEUCHTUNG**
WHITE LIGHT LED MODULE FOR OBJECT LIGHTING
MODULE À LED À LUMIÈRE BLANCHE POUR ÉCLAIRER DES OBJETS

(30) Priorität: 17.05.2013 DE 102013209220; 27.08.2013 DE 102013217055
(43) Veröffentlichungstag der Anmeldung: 23.03.2016
(73) Patentinhaber: Tridonic Jennersdorf GmbH, 8380 Jennersdorf (AT)
(72) Erfinder: PACHLER, Peter, 8042 Graz (AT)
(74) Vertreter: Rupp, Christian
(86) Internationale Anmeldenummer: PCT/EP2014/058866
(87) Internationale Veröffentlichungsnummer: WO 2014/184000

(56) Entgegenhaltungen:
- DE-A1-102008 021 572
- DE-A1-102010 046 790
- DE-A1-102011 111 920
- US-A1- 2011 220 920

## Beschreibung

Die Erfindung betrifft ein Weisslicht-LED-Modul, das es erlaubt, Objekte mit einem spezifischen Weisslicht zu beleuchten, wobei das Weisslicht-LED-Modul auf die spezielle Anwendung ausgelegt ist.

Ein Aspekt der Erfindung bezieht sich insbesondere darauf, LED-Module für die Beleuchtung von Textilien, beispielsweise Kleidungsstücken, bereitzustellen, die eine vorteilhafte Beleuchtung insbesondere weisser, aber auch roter Stoffe/Textilien erlaubt.

Problematisch ist, dass bekannte LED-Module, die Licht mit einer Lichttemperatur von ca. 3000K (3000 Kelvin) und einen Farbwiedergabeindex (Rₐ, Ra, CRI) von 90 emittieren, eher ein "schmutzig" gelbes Licht erzeugen. Dies kann insbesondere bei einer Beleuchtung von weissen Textilien die Wiedergabe eines strahlendes Weisses in Richtung eines gelblichen Weisses verändern. Dies fällt insbesondere bei einem Vergleich einer Beleuchtung mit den bekannten LED-Modulen mit einer Beleuchtung mit Gasentladungslampen auf, wobei geschulte Personen auch eine absolute Farbabweichung erkennen können.

DE 10 2010 046790 beschreibt ein optoelektronisches Halbleiterbauelement mit zumindest zwei Halbleiterchips und einem ersten Strahlung grüner Wellenlänge emittierenden Konversionsstoff und einem zweiten Strahlung roter Wellenlänge emittierenden Konversionsstoff.

In einem anderen Aspekt stellt die Erfindung ein LED-Modul bereit, das es erlaubt, eine geringe Varianz des emittierten Lichts bereitzustellen, bei dem für alle Teilfarben von einem Farbwiedergabewert von >90 und eine möglichst geringe Varianz zugesichert werden kann.

Entscheidend ist in beiden Fällen, dass der Farbwiedergabeindex Rₐ des LED-Moduls ≥ 90 ist, d.h. dass die Abweichung der Sekundärspektren des LED-Moduls, beispielsweise der nach DIN 6169 ausgewählten 14 Testfarben, insgesamt bei integraler Betrachtung um weniger al 10% von denen einer Bezugslichtquelle, beispielsweise eines Temperaturstrahlers mit Rₐ 100 unterscheiden.

Insgesamt muss das LED-Modul gemäß der Erfindung also einen Farbwiedergabeindex von 90 oder höher aufweisen. Es werden also die Farbwiedergabewerte der Testfarben (oder einer Auswahl davon; z.B. wird eine Auswahl aller 14 Testfarben mit Rₐ 14 bezeichnet, eine Auswahl von z.B. 8 Testfarben mit Rₐ 8, ...) bei Beleuchtung mit der zu untersuchenden Lichtquelle und der Bezugslichtquelle bestimmt, die für die entsprechende Farbtemperatur gewählt ist, z.B. für 3000K oder 3250K.

Die Erfindung stellt daher ein LED-Modul gemäß der unabhängigen Ansprüche bereit. Weitere Ausprägungen der Erfindung sind Gegenstand der abhängigen Ansprüche.

Das Weisslicht-LED-Modul kann weisses Licht mit einer Farbtemperatur von 3245K - 3255K, insbesondere 3250K emittieren. Das Weisslicht-LED-Modul kann auch weisses Licht mit einer Farbtemperatur von 2900K -3100K, insbesondere 3000K, oder mit einer Farbtemperatur von 2500K - 3000K, insbesondere 2750K emittieren.

Der Farbort des emittierten weissen Lichts kann im CIE-Normfarbsystem, insbesondere CIE 1931 (CIE = Commission internationale de l'éclairage), durch die Werte x = ca. 0,4112 - ca. 0,4225 und y = ca. 0,3837 - ca. 3987 definiert sein. Insbesondere kann der zentrale Farbort bei x=0,4177 und y=0,3918 liegen. Alternativ kann CIE 1964 gewählt werden.

Das emittierte weisse Licht kann einen Farbwiedergabeindex Rₐ von wenigstens 90 aufweisen.

Das Weisslicht-LED-Modul kann einen weiteren LED-Chip anderer Art aufweisen, der Licht im blauen Spektrum, vorzugsweise im Bereich von 405 nm - 425 nm, insbesondere im Bereich von 410 nm - 420 nm emittiert.

Der Anteil der LED-Chips anderer Art an der Gesamtanzahl der LED-Chips kann zwischen 5% und 30%, vorzugsweise 10% - 25% betragen.

Wenigstens eines der Farbkonversionsmaterialien kann in einem Dispens- oder Damm-and-Fill-Verfahren auf das Weisslicht-LED-Modul aufgebracht sein.

Das Weisslicht-LED-Modul kann wenigstens ein weiteres Farbkonversionsmaterial aufweisen, vorzugsweise ein Nitrid, das eine dominante Emissions-Wellenlänge im roten Spektrum aufweist, vorzugsweise im Bereich von 625 - 635 nm und insbesondere bei 630 nm.

Die Farbkonversionsmaterialien können jeweils zumindest teilweise auf den LED-Chips aufgebracht sein.

In einem weiteren Beispiel wird ein Weisslicht-LED-Modul mit wenigstens zwei LED-Chips bereitgestellt, wobei ein erster LED-Chip Licht im blauen Spektrum in einem ersten Bereich emittiert, und ein zweiter LED-Chip Licht im blauen Spektrum in einem zweiten Bereich emittiert, und wobei das LED-Modul weiterhin aufweist: ein erstes Farbkonversionsmaterial, vorzugsweise LuAG, das eine dominante Emissions-Wellenlänge im grünen Spektrum aufweist, vorzugsweise im Bereich von 475 nm - 625 nm und insbesondere im Bereich von 500 nm - 575 nm, und eine zweites Farbkonversionsmaterial, vorzugsweise ein Nitrid, das eine dominante Emissions-Wellenlänge im roten Spektrum aufweist, vorzugsweise im Bereich von 645 nm - 655 nm und insbesondere bei 650 nm.

Der erste und der zweite Bereich können disjunkt sein.

Der erste Bereich kann Wellenlängen von 440 nm - 455 nm, insbesondere von 445 nm - 447,5 nm aufweisen, und der zweite Bereich kann Wellenlängen von 450 nm - 465 nm, insbesondere von 457,5 nm - 462,5 nm aufweisen.

Der erste kann Bereich Wellenlängen kann von 447,5 nm - 450,0 nm aufweisen.

Der erste Bereich kann Wellenlängen von 440 nm - 455 nm, insbesondere von 447,5 nm - 450 nm aufweisen, und der zweite Bereich kann Wellenlängen von 450 nm - 465 nm, insbesondere von 457,5 nm - 460 nm aufweisen.

Der erste Bereich kann Wellenlängen von 440 nm - 455 nm, insbesondere von 447,5 nm - 450 nm aufweisen, und der zweite Bereich kann Wellenlängen von 455 nm - 465 nm, insbesondere von 460 nm - 462,5 nm aufweisen.

Der erste Bereich kann Wellenlängen von 445 nm - 455 nm, insbesondere von 450 nm - 452,5 nm aufweisen, und der zweite Bereich kann Wellenlängen von 455 nm - 465 nm, insbesondere von 457,5 nm - 460 nm aufweisen.

Der erste Bereich kann Wellenlängen von 445 nm - 455 nm, insbesondere von 450 nm - 452,5 nm aufweisen, und der zweite Bereich kann Wellenlängen von 455 nm - 465 nm, insbesondere von 460 nm - 462,5 nm aufweisen.

Wenigstens ein LED-Chip kann kein Farbkonversionsmaterial aufweisen, das eine dominante Emissions-Wellenlänge vorzugsweise im Bereich von 625 nm - 635 nm und insbesondere bei 630 nm aufweist.

Das emittierte weisse Licht kann eine Chromatizität aufweisen, die in einer MacAdam Ellipse um den zentralen Fabort liegen, insbesondere einer MacAdam3 Ellipse, und vorzugsweise eine 3SDCM (Standard Deviation of Color Matching or size of MacAdam ellipse) Homogenität aufweisen.

Das erste Farbkonversionsmaterial kann bestehen aus oder aufweisen einem/ein Granatmaterial und/oder aus einer/eine Auswahl aus einer Gruppe von Granatmaterialien, aufweisend ein Cer, Ce3+, dotiertes Lutetium, ein Cer, Ce3+, dotiertes Yttrium oder ein Cer, Ce3+, dotiertes Oxid, oder eine Kombination daraus. Beispielsweise kann das erste Farbkonversionsmaterial bestehen aus oder aufweisen LuAG:Ce3+, YAG:Ce3+, (Y, Gd)AG: Ce3+, (Y, Lu)AG:Ce3+ oder CaSc204:Ce3+ oder eine Kombination daraus.

Das zweite Farbkonversionsmaterial kann bestehen aus oder aufweisen einer/eine Auswahl aus einer Gruppe von Europium, Eu2+, dotierten Nitriden oder Silikaten, insbesondere Oxy-Ortho-Silikaten, oder einer Kombination daraus. Beispielsweise kann das zweite Farbkonversionsmaterial bestehen aus oder aufweisen CaAlSiN3:Eu2+, (Ca,Sr)AlSiN3:Eu2+, (Ca,Sr)2Si5N8:Eu2+, (Sr,Ba)3SiO5:Eu2+ oder eine Kombination daraus.

Die Erfindung wird nunmehr auch mit Bezug auf die Figuren beschrieben. Dabei zeigt
- Fig. 1: einen Vergleich eines Auflichtspektrums einer Gasentladungslampe mit einem Spektrum eines Temperaturstrahlers bei 3250K;
- Fig. 2: Farbwiedergabewerte eines LED-Moduls;
- Fig. 3: Farbkoordinaten einer Gasentladungslampe;
- Fig. 4: einen Vergleich einer Spektralverteilung eines Erfindungsgemäßen LED-Moduls mit dem der Gasentladungslampe;
- Fig. 5: Spektren dreier erfindungsgemäßer LED-Module;
- Fig. 6: Farbwiedergabewerte eines der drei erfindungsgemäßen LED-Module aus Fig. 5;
- Fig. 7: einen Vergleich des Spektrums des erfindungsgemäßen LED-Moduls aus Fig. 5 (schwarz) im Vergleich zum Temperaturstrahler (grau) bei 3250K;
- Fig. 8: eine schematische Darstellung eines Toleranzbereiches des erfindungsgemäßen LED-Moduls aus Fig. 5;
- Fig. 9: einen Vergleich der Spektren des erfindungsgemäßen LED-Moduls aus Fig. 5 mit einem weiteren erfindungsgemäßen LED-Modul.
- Fig. 10: Farbwiedergabewerte eines LED-Moduls mit einem unmodifizierten LED-Chip bei 3000K (mittlere Spalte) mit Rₐ 90 und einem modifizierten LED-Chip bei 3000K (rechts);
- Fig. 11: ein Spektrum eines LED-Moduls bei 3000K und mit Rₐ 90 LED-Chip im Vergleich zum Temperaturstrahler (Rₐ 100), ohne Modifikation des LED-Chips;
- Fig. 12: ein Spektrum eines LED-Moduls bei 3000K und mit Rₐ 90 LED-Chip im Vergleich zum Temperaturstrahler (Rₐ 100) mit Modifikation der LED-Chips;
- Fig. 13: Farbwiedergabewerte des LED-Moduls für verschiedene Wellenlängen der blauen LED-Chips zentral und am Rand einer MacAdam3 Ellipse für 3000K;
- Fig. 14: Farbwiedergabewerte von LED-Modulen für verschiedene Kombinationen von LED-Chips mit blauen Emissions-Wellenlängen, zentral und am Rand der MacAdam3 Ellipse für 3000K;
- Fig. 15: eine schematische Darstellung problematischer Bereiche bei einem Rₐ >90;
- Fig. 16: beispielhaft integrale CIE Koordinaten des erfindungsgemäßen LED-Moduls, wobei Punkte Farborte bei niedriger Betriebstemperatur (kalt/ca. 25°C), wie sie z.B. bei einem gepulsten Betrieb der LED-Chips auftreten, und wobei Rechtecke Farborte bei höherer Betriebstemperatur (ca. 65°C), wie sie z.B. bei einem stetigen (steady state) Betrieb der LED-Chips auftreten, zeigen;
- Fig. 17: eine spektrale Verteilung für ein erfindungsgemäßes LED-Modul bei kaltem/gepulsten Betrieb (hellgrau) und 65°C/stetigem Betrieb;
- Fig. 18: Farbwiedergabewerte eines erfindungsgemäßen LED-Moduls bei 25°C (oben) und 65°C (unten);
- Fig. 19: Farborte eines LED-Moduls;
- Fig. 20: Farbwiedergabewerte bei 25°C gepulstem Betrieb, 25°C stetigem Betrieb, 65°C stetigem Betrieb und 85°C stetigem Betrieb.

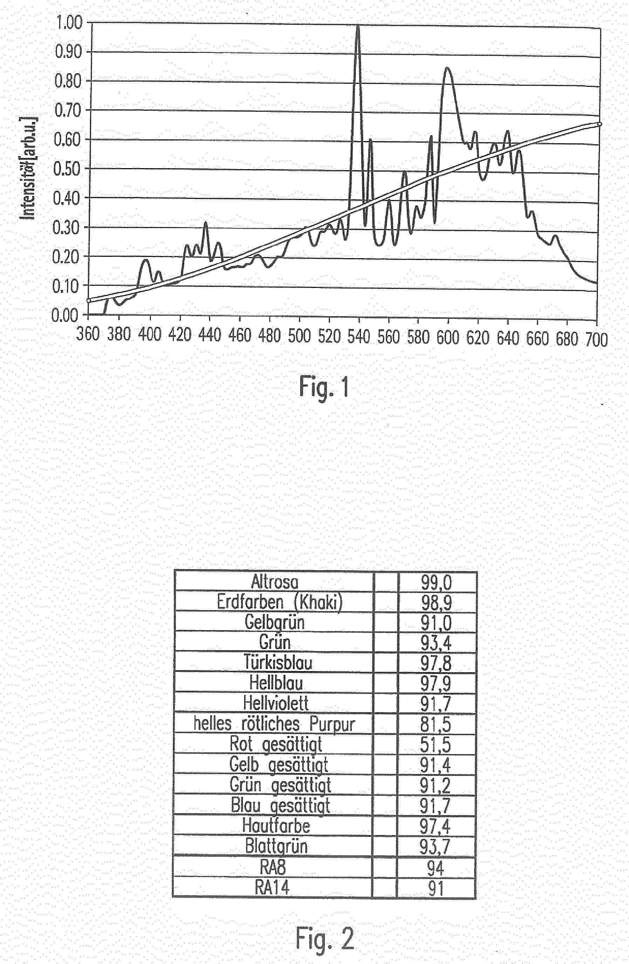

Fig. 1 zeigt ein Auflichtspektrum einer zur Beleuchtung von Textilien geeigneten Gasentladungslampe (schwarze Kurve) zu einem Spektrum eines Temperaturstrahlers bei 3250 Kelvin (graue Kurve). Hier weist die Gasentladungslampe eine Klassifikation von 930 auf, was einem Farbwiedergabeindex Rₐ 90 bei einer Temperatur von 3000 Kelvin entspricht.

Dabei ist zu erkennen, dass ein Vergleich des Spektrums der Gasentladungslampe mit dem Spektrum des Temperaturstrahlers wie in Fig. 1 gezeigt im Mittel keine großen Abweichungen aufweist. Lediglich im Bereich um ca. 440 nm kann eine etwas erhöhte Intensität festgestellt werden, wohingegen im Bereich um ca. 470 nm die Intensität verglichen zum Temperaturstrahler etwas reduziert ist. Um ca. 540 nm weist das Spektrum einen Spitzenwert (Peak) im grünen Bereich des Lichtspektrums auf. Bei ca. 605 nm ist ebenfalls ein Peak im Bereich des rot-orangen Spektrums des sichtbaren Lichts festzustellen.

Fig. 2 zeigt in einer Tabelle die Farbwiedergabewerte der Gasentladungslampe für die 14 Testfarben, wobei in den letzten zwei Zeilen der Tabelle der Farbwiedergabeindex für eine Auswahl von 8 der 14 Farben (RA8) berechnet ist, während die letzte Zeile den Farbwiedergabeindex für alle 14 Testfarben (RA14) anzeigt.

Hieraus ist ersichtlich, dass die Farbwiedergabe allgemein sehr gut ist, der Farbwiedergabewert für gesättigtes Rot jedoch vergleichsweise gering ist. Dies ist durch den in Fig. 1 gezeigten Spitzenwert bei ca. 605 nm zu erklären, durch den zu wenig tiefrotes Licht in dem Auflichtspektrum vorhanden ist, was insbesondere bei Textilien zu leicht blasseren und dunkleren roten Farben führt.

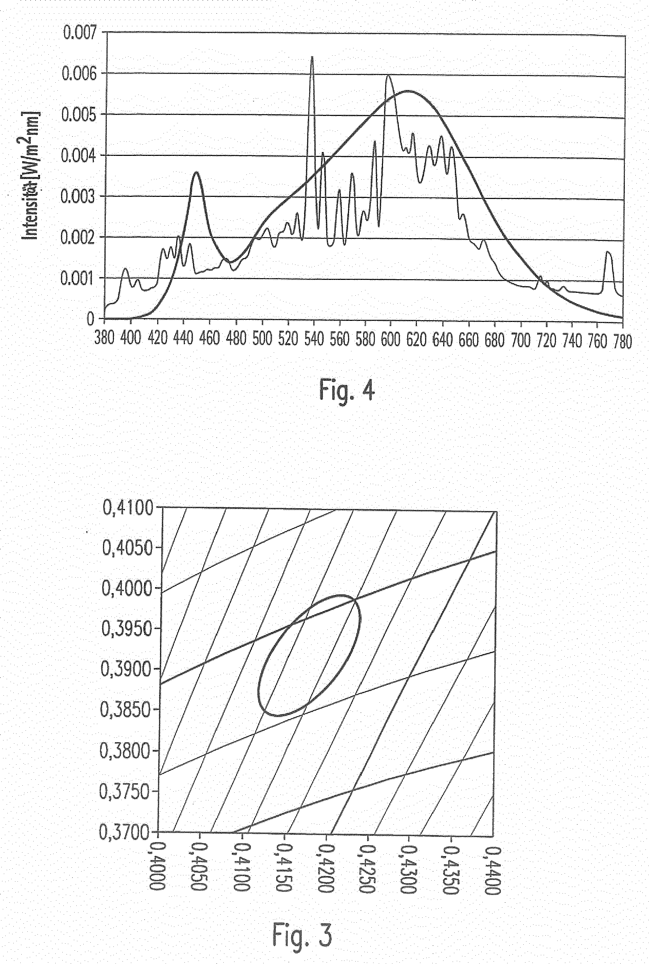

Die Fig. 3 zeigt beispielhaft die Farbkoordinaten der Gasentladungslampe, wobei der Farbort des von der Lampe emittierten Lichts bei 3250K unter der Planckschen Kurve liegt. In Fig. 3 ist zudem eine MacAdam-Ellipse dargestellt, die bekanntermaßen eine Art Toleranzbereich darstellt innerhalb dem Abweichungen in der Farbwiedergabe von dem menschlichen Auge nicht wahrgenommen werden, d.h. Farborte bzw. Farbabweichungen vom Zentrum (Mittelpunkt) innerhalb der Ellipse werden vom menschlichen Auge als Wiedergabe der gleichen Farbwerts wahrgenommen, sofern keine Fehlsichtigkeit oder Farbenblindheit vorliegt. Insbesondere kann die Chromatizität, bzw. die Farbsättigung, in dem Tolleranzbereich.

Kern der Erfindung ist es nunmehr ein Weisslicht-LED-Modul bereitzustellen, das sich ebenfalls für die' Beleuchtung von Textilien, insbesondere von weissen Textilien, eignet, so dass die positiven Eigenschaften der LED-Technik (Lebensdauer und Energieeffizienz) sich auch hier positiv auswirken können.

Zunächst kann das von dem Weisslicht-LED-Modul abgegebene Licht durch Farbkonversionsmaterialien verändert werden, beispielsweise durch das Aufbringen von Phosphoren, die z.B. einen Farbwiedergabeindex von 80 (Rₐ 80) erlauben. Hierbei ist zu beachten, dass der MacAdam Toleranzbereich verschoben ist, da in dem CIE-Normfarbsystem, beispielsweise CIE 1964 oder CIE 1931, die Darstellung von der Planckschen Kurve versetzt ist. Um dem Rechnung zu tragen, ist der Toleranzbereich leicht verschoben.

Durch den Einsatz der genannten Phosphore, bzw. des Farbkonversionsmaterials oder der Farbkonversionsmaterialien, kann jedoch oft kein optimales Licht erzeugt werden, was auch aus dem Verhalten eines Weisslicht-LED-Modul nach diesem Aufbau im Vergleich zu dem der Gasentladungslampe, wie es in dem in Fig. 4 gezeigten Spektrum gezeigt ist, ersichtlich ist.

Um das abgegebene Spektrum weiter zu verbessern wird nun zudem beachtet, dass kurze Peak-Wellenlängen, beispielsweise im Bereich von ca. 430 nm als störend (violette Farbverschiebung) während Peaks bei größeren Wellenlängen eher positiv wahrgenommen werden, wobei diese jedoch einen Einfluss auf die Farbwiedergabe bei weissen Materialien haben können.

Daher wird erfindungsgemäß ein Spektrum erzeugt, das ein Blau bei kürzerer Wellenlänge aufweist und insgesamt die Farbwiedergabe auf einen Farbwiedergabeindex von 90 erhöht.

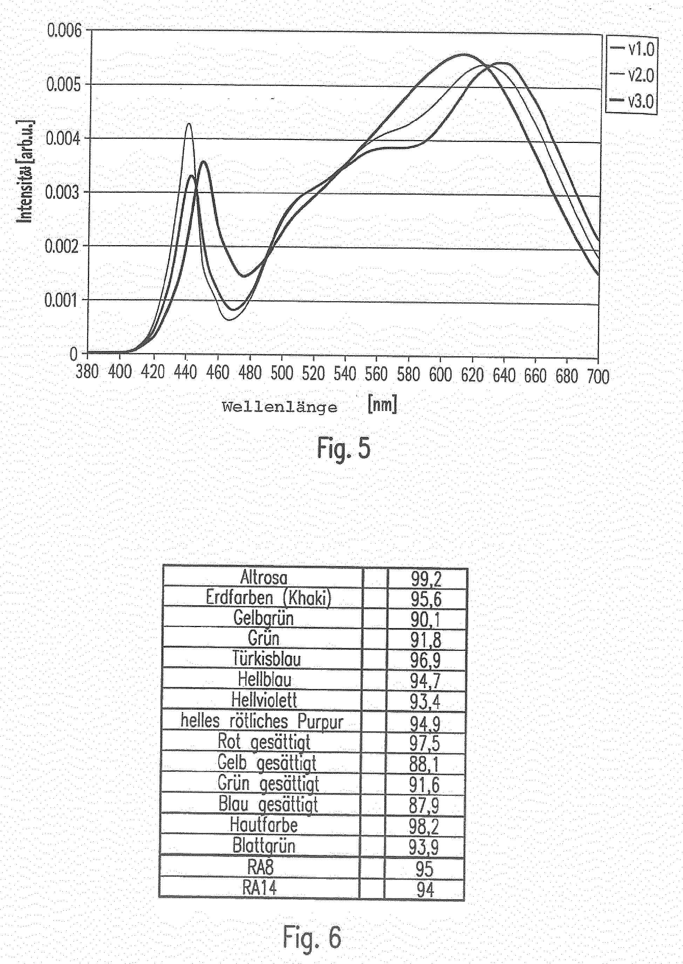

Fig. 5 zeigt Spektren von LED-Modulen, die in dieser Hinsicht angepasst wurden.

Fig. 6 zeigt dabei tabellarisch die Farbwiedergabewerte für die Testfarben des in Fig. 5 mit Variante 3 (V3.0) bezeichneten Spektrums, wobei hiermit die Kurve bezeichnet ist, die bei ca. 600 nm die geringste Intensität aufweist.

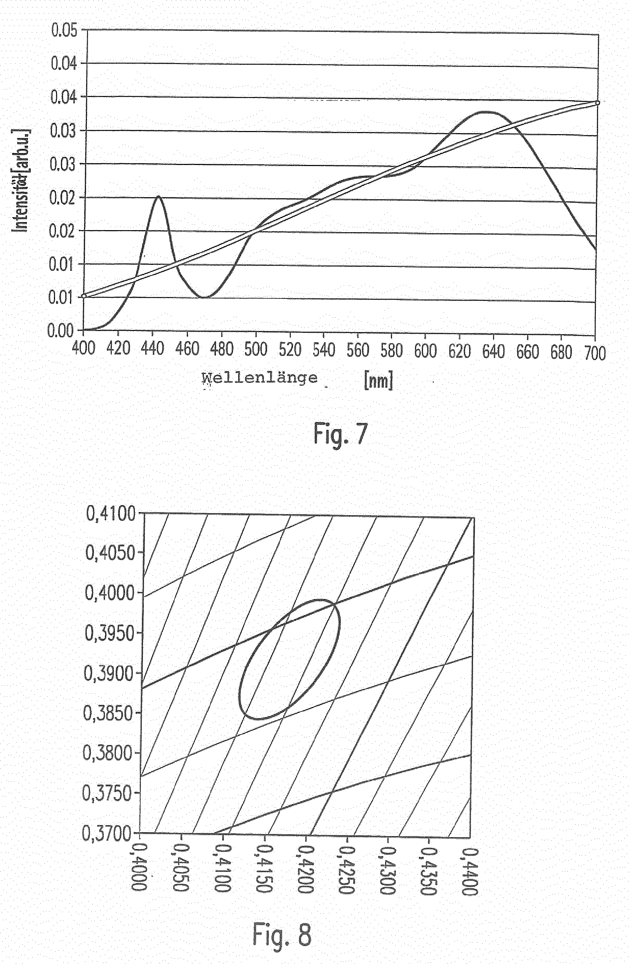

Ein Vergleich dieses Spektrums V3.0 mit einem Temperaturstrahler (Rₐ 100) bei 3250K, ist in Fig. 7 dargestellt. Der Fig. 7 kann dabei entnommen werden, dass hier im Mittel durchgehend ein Farbwiedergabeindexwert von über 90 (Rₐ 90) erreicht wird und dass insbesondere auch die Farbwiedergabe im roten Bereich bzw. im Bereich "Rot gesättigt" über 90 liegt. Lediglich im Bereich des blauen Lichts sind signifikantere Abweichungen von der Kennlinie des Temperaturstrahlers zu erkennen.

In dem Weisslicht-LED-Modul kommt insbesondere wenigstens ein LED-Chip zum Einsatz, der Licht im blauen Spektrum, beispielsweise bei einer Wellenlänge im Bereich von ca. 440 nm bis ca. 455 nm, insbesondere im Bereich von ca. 445 bis ca. 450 nm, abstrahlt und das ein Farbkonversionsmaterial aufweist, insbesondere ein erstes Farbkonversionsmaterial, vorzugsweises einen Phosphor, das angeregt Licht mit einer dominanten Wellenfänge im grünen Spektrum emittiert, beispielsweise LuAG (Lutetium-Aluminium-Granat), und ein zweites Farbkonversionsmaterial, vorzugsweise einen Phosphor, das bei Anregung Licht einer dominanten Wellenfänge im roten Bereich des sichtbaren Spektrums emittiert, insbesondere bei ca. 650 nm oder im Bereich von ca. 645 nm bis 655 nm (Nitrit, BR 101h).

Es kommen also vorzugsweise zwei Farbkonversionsmaterialen zum Einsatz, wobei das emittierte weisse Licht einen Anteil des von dem LED-Chip emittierten Lichts im blauen Spektrum, einen Anteil, der durch das erste Farbkonversionsmaterial, das eine dominante Emissions-Wellenlänge im grünen Spektrum aufweist, erzeugt wird und einen Anteil, der durch das zweite Farbkonversionsmaterial, das eine dominante Emissions-Wellenlänge im roten Spektrum aufweist, erzeugt wird, aufweist.

Um eine besonders günstige Wirkung zu erzielen, muss sich das von dem LED-Modul abgegebene weisse Licht, bzw. Der Farbort des Auflichtspektrums innerhalb eines Toleranzbereichs bewegen, wie er in Fig. 8 dargestellt ist. Dabei wird für eine Farbtemperatur von 3250K ein chromatischer Zielort definiert, dessen Koordinaten bei ca. 0,4177 auf der Y-Achse des CE-Norm Farbraums CIE 1931 auf der X-Achse und bei 0,3918 auf der Y-Achse in diesem Farbraum liegt. Das Toleranzfeld ist wie bereits gesagt durch eine MacAdam Ellipse dargestellt (3SDCM). Der Farbort des emittierten weissen Licht im CIE-Normfarbsystem, insbesondere CIE 1931, ist dabei vorzugsweise durch die Werte x = ca. 0,4112 - ca. 0,4225 und y = ca. 0,3837 - ca. 3987 definiert.

Für den wenigstens einen LED-Chip des Weisslicht-LED-Modulwird z.B. ein Betriebsstrom von bspw. 120 mA gewählt, wobei der gewählte LED-Chip vorzugsweise eine Leistung von ca. 110 mW bei 65°C und eine Effizient von ca. 75 Lumen pro Watt (lm/W) erreicht. Wird ein Wandler zum Betrieb des LED-Moduls mit 89% Wirkungsgrad verwendet, ist auch eine Effizienz von 80 lm/W zu erreichen. Die Performanz der Gasentladungslampen mit Vorschaltgerät liegt dabei bei ca. 94 lm/W, wenn Alterungseffekte über einen Lebenszyklus von ca. 15.000 Stunden mitberücksichtigt werden bei etwa 84 lm/W. Der Effizienzunterschied kann durch geringere Bestromung ausgeglichen werden. Wird auf die verbesserte Farbwiedergabe für rote Farben verzichtet so, kann an Effizienz des LED-Moduls weiter gesteigert werden. Eine Anpassung im Vergleichszeitraum von ca. 15.000 Stunden ist bei LEDs marginal und bei ca. 30.000 Stunden können im Mittel noch 76 lm/W erwartet werden. Bei gleicher Effizienz haben LEDs jedoch eine bessere Farbwiedergabe und ein besseres Lebensdauerverhalten.

Natürlich kann auch vorgesehen sein, ein Weisslicht-LED-Modul bereitzustellen, das eine entsprechende Funktionalität bei 3000K bzw. 2750K unter Verwendung des gleichen LED-Chips bzw. der gleichen Farbkonversionsmaterialien und der gleichen relativen Lage zur Planckschen Kurve ermöglicht.

Alternativ kann zusätzlich zu dem wenigstens einen LED-Chip, der vorzugsweise Licht im Bereich von 445 nm bis 450 nm abstrahlt ein weiterer LED-Chip zum Einsatz kommen, der nicht im Bereich des tiefblauen Lichts liegt, insbesondere im Wellenlängen Bereich von ca. 405 nm bis ca. 425 nm ( nm, Nanometer) und insbesondere im Bereich von ca. 410 nm bis ca. 420 nm emittiert.

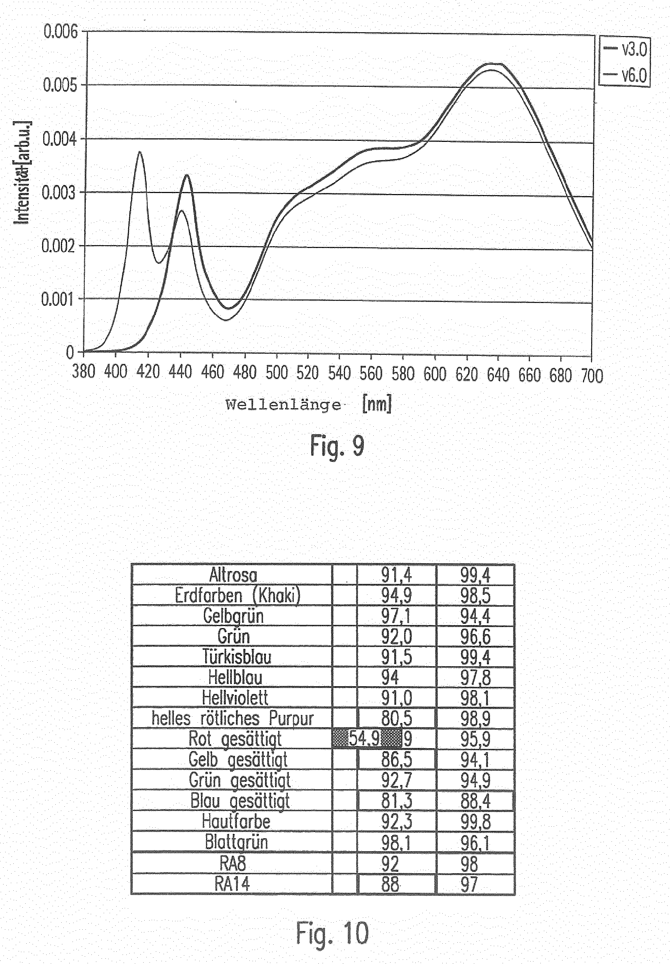

Das Spektrum einer entsprechenden Lösung ist in Fig. 9 dargestellt. Das in Fig. 9 dargestellte Spektrum der Variante V6.0 (graue Kurve) zeigt im Vergleich zu der oben beschriebenen Variante V3.0 (schwarze Kurve) ein deutlich "strahlenderes" Weiss und eine bessere Farbakzentuierung. Durch Variierung der Peaks kann der Effekt, der beim Betrachter den Eindruck eines strahlenden Weisses hervorruft, bei Bedarf verändert werden.

Das LED-Modul weist dabei insbesondere eine Effizienz von 70% - 80% und insbesondere von 75% auf, wobei diese Effizienz erreicht wird, wenn bspw. drei Chips, die blaues Licht imitieren, mit einem Chip, der tiefblaues Licht imitiert, kombiniert werden, also ein Verhältnis von 75% zu 25% vorliegt. Dabei ist jedoch vorgesehen, dass vorzugsweise der Anteil der LED-Chips mit tiefblauem Licht auf bspw. 10% gesenkt wird, um den Einfluss auf die Gesamteffizient minimal zu halten. Dabei ist vorteilhaft, dass eine große Anzahl von blauen Chips zur Verfügung steht, die jeweils passend kombiniert und eingesetzt werden können, um die entsprechenden Peakwerte wunschgemäß variieren zu können.

Insbesondere für die Beleuchtung von Textilien ist in dem LED-Modul also eine Kombination von Chips mit dominanter Wellenlänge zwischen vorzugsweise ca. 445 nm bis ca. 450 nm vorgesehen, die zumindest Teilweise Phosphore Farbkonversionsmaterialien aufweisen, die angeregt Licht mit einer dominanten Emissions-Wellenlänge im grünen und/oder roten Spektrum emittieren. Es können hierbei wie gesagt LuAG oder Nitrit verwendet werden. Der resultierende Farbort am beleuchteten Objekt ist dabei vorzugsweise entsprechend des Toleranzbereichs aus Fig. 8 eingestellt.

Um beim Betrachter vor allem beim Betrachten von Textilien einen noch stärkeren Effekt des "Leuchtens", bzw. "Strahlens" des Weisses hervorzurufen, können also Chips mit Peak-Wellenlängen von ca. 410 nm bis ca. 420 nm anteilig beigemengt werden, wobei der Anteil der Beimengung ca. 10 - 25% beträgt. Dabei kann insbesondere der Anteil der Farbwiedergabe im roten Spektrum reduziert werden, um die Effizienz weiter zu steigern, beispielsweise um ca. 10% - 20%.

In einem anderen Aspekt betrifft die Erfindung ein Weisslicht-LED-Modul, das sich insbesondere dafür eignet, in Umgebungen eingesetzt zu werden, in denen Anteile des Tageslichts bzw. des von Gasentladungslampen emittierten Lichts unerwünscht sind. Insbesondere können Anteile des ultravioletten Lichts (UV) bzw. des Infrarot-Lichts (IR) unerwünscht oder lediglich in geringem Ausmaß erwünscht sein. Dies ist beispielsweise in Museen oder Räumen der Fall, in denen Diese Lichtanteile schädlich auf die beleuchteten Objekte wirken.

Insbesondere ist für diese Anwendung eine Farbtemperatur von 3000Kelvin interessant. Es ist dabei eine hochwertige Beleuchtung erwünscht, wobei hochwertig hier als Beleuchtung definiert ist, bei der die Farbwiedergabewerte für alle Teilfarben ≥ 90 sind und eine Varianz in der Farbwiedergabe der verwendeten Leuchtmittel gering und insbesondere durch eine McAdam3-Ellipse beschränkt ist.

Ausgangspunkt sind hier Weisslicht-LED-Module mit einem Farbwiedergabeindex von > 90 (Rₐ > 90) bei 3000K, mit einem reduzierten Farbanteil im roten und blauen Spektrum.

Diese weisen für gesättigte Rot-Farben aus Effizienzgründen Reduktionen auf, da längerwellige Rotanteile zu Lichtstromeinbußen führen können. Im blauen Spektrum ist die Emission reduziert, da sich Emissionen im blauen Spektrum in der Wahrnehmung des Betrachters stärker auswirken.

Die Tabelle in Fig. 10 zeigt daher die Farbwiedergabewerte für die Testfarben bei 3000K, wobei das verwendete Weisslicht-LED-Modul Farbkonversionsschichten aufweist, wie beispielsweise Phosphore, die bei Anregung dominante Emissions-Wellenlänge im grünen (LuAG) oder im roten Spektrum z.B. Nitrid, bei ca. 630 nm und bei ca. 650 nm aufweisen (mittlere Spalte).

Wird jedoch auf das Farbkonversionsmaterial mit dominanter Emissions-Wellenlänge im Bereich von 630 nm verzichtet, so wird der Farbwiedergabeindex insgesamt auf ≥ 90 verbessert (siehe rechte Spalte und letzte Zeile der Tabelle aus Fig. 10 für RA14) und die Farbwiedergabewerte aller Farben bis auf ,blau gesättigt' auf einen Wert über 90 erhöht.

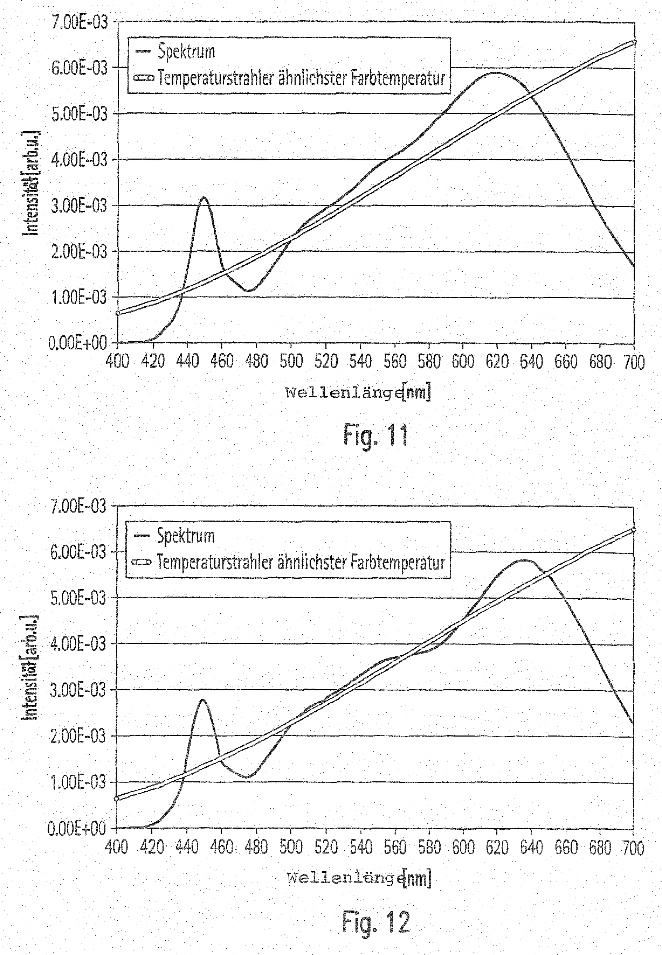

In den Abbildungen 11 und 12 ist jeweils ein Spektrum eines LED-Moduls mit Farbwiedergabeindex Rₐ 90 bei 3000 Kelvin in Vergleich zu einem Temperaturstrahler mit Farbwiedergabeindex 100 (Rₐ 100) gezeigt.

Die Fig. 12 zeigt dabei ein Spektrum eines LED-Moduls mit lediglich einem Farbkonversionsmaterial, insbesondere einem Phosphor, das bei Anregung Licht mit einer dominanten Emissions-Wellenlänge von ca. 650 nm, also im roten Bereich des sichtbaren Lichts, emittiert.

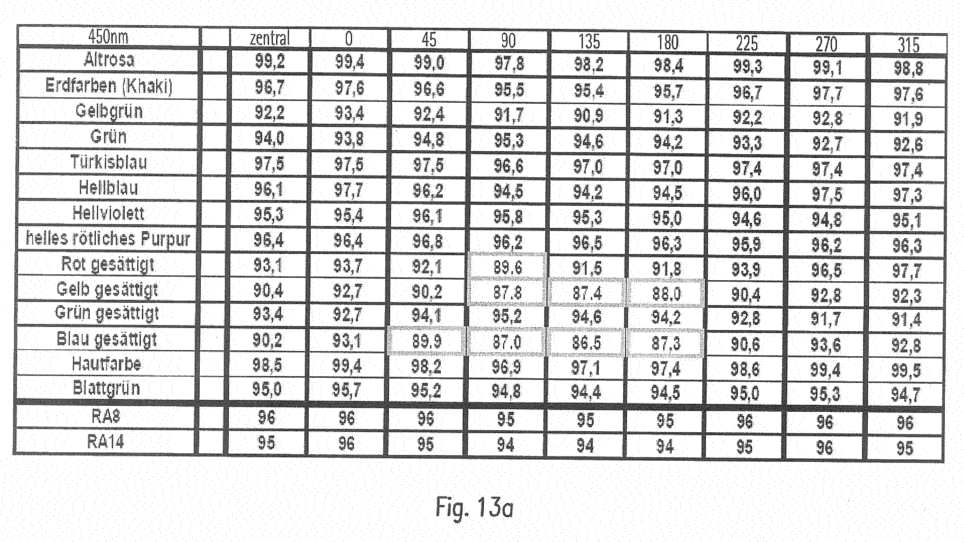

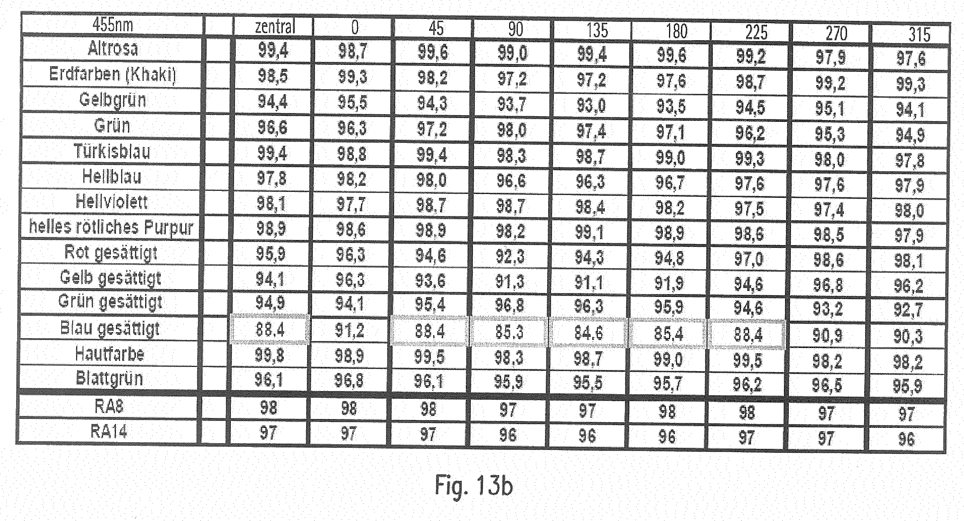

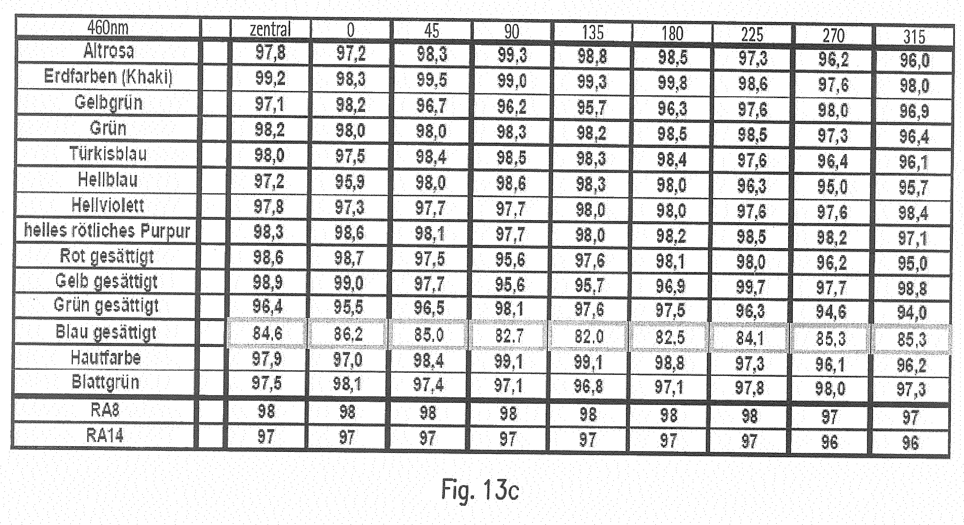

Fig. 13 zeigt weiter eine Tabelle für verschiedene LED-Chips, die blaues Licht emittieren, zentral und am Rand einer MacAdam3-Ellipse bei 3000K. Daraus ist ersichtlich, dass bei LED-Chips, die im Bereich um ca. 450 nm emittieren, bei den gesättigten Farben Rot, Grün und Blau zu geringe Werte auftreten, während sich bei LED-Chips, die im Bereich um 460 nm emittieren, zu geringe Werte bei gesättigtem Blau ergeben. Während Versuche gezeigt haben, dass andere Phosphorkombinationen zu noch geringeren Werten führen, ist vorgesehen, sofern eine verringerte Effizienz zulässig ist, eine Kombination mit einem im längerwelligen Rotbereich emittierenden Phosphor zu wählen.

Insbesondere ist das Modul daher mit wenigstens zwei LED-Chips ausgestattet, wobei ein LED-Chip einen kürzerwelligen Bereich des blauen Spektrums emittiert, während der andere Chip in einen längeren Wellenlängenbereich des blauen Spektrums emittiert.

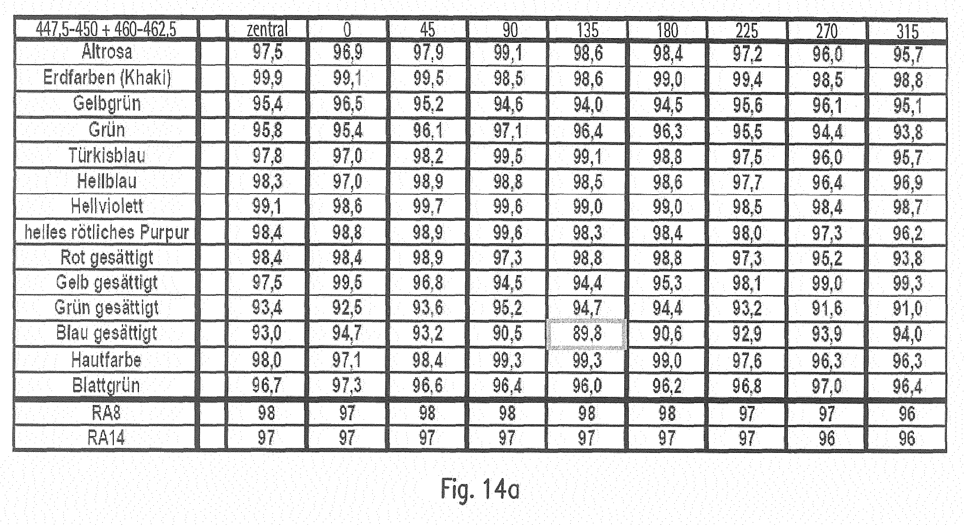

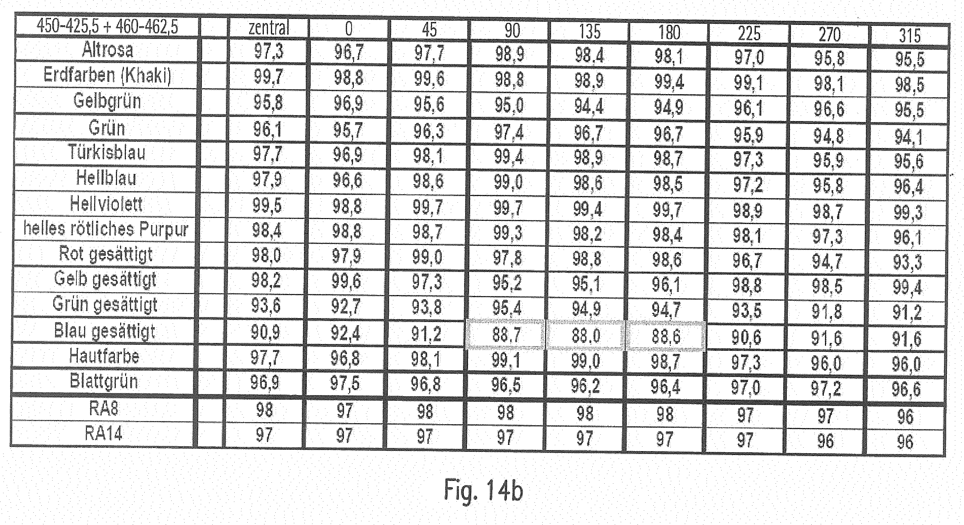

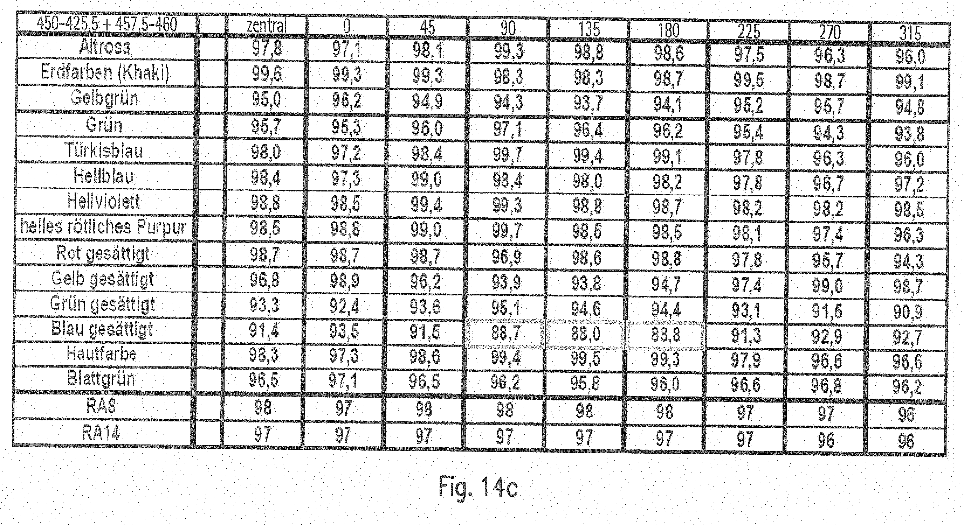

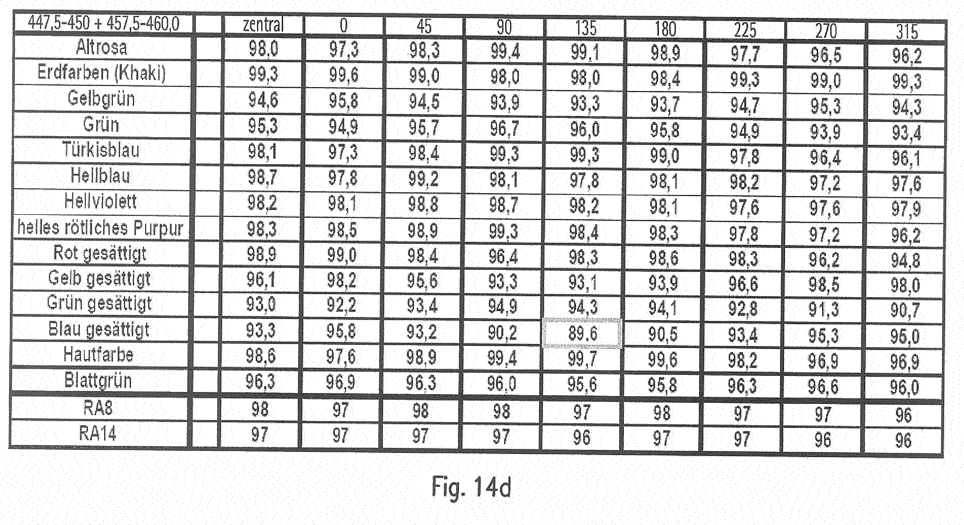

Die Tabelle in Fig. 14 zeigt wiederum Farbwiedergabewerte für LED-Module mit Kombinationen von blauen LED-Chips, die Licht in verschiedenen Wellenlängenkombinationen emittieren, zentral und am Rand der MacAdam3-Ellipse bei 3000K.

Auch hier ist zu erkennen, dass nicht alle Farbwiedergabewerte über 90 liegen, allerdings bleiben lediglich Werte für "gesättigtes Blau" unterhalb der Farbwiedergabewertgrenze von 90. Diese Kombinationen erfüllen jedoch generell die Forderung nach einem Farbwiedergabeindex von 90 (Rₐ 90), da lediglich ein Teilbereich, nämlich der genannte Bereich im blauen Spektrum (für 90, 135, 180°C, bzw. bei 135°C), unter dem Farbwiedergabewert 90 liegt.

Wählt man statt des Toleranzbereichs der MacAdam3-Ellipse eine McAdam2-Ellipse, bei der einer der LED-Chips im Bereich von ca. 405 nm bis ca. 452,5 nm emittiert, so liegt ein kleiner Teilbereich um 135°C oberhalb der Planckschen Kurve unterhalb eines Farbwiedergabewertes von 90. Betrachtet man hingegen die MacAdam1-Ellipse, so sind alle Bereiche der Teilfarben oberhalb der Grenze von 90.

Die bevorzugte Kombination von LED-Chips besteht hingegen in einer Kombination, bei der ein LED-Chip im Bereich von ca. 445 nm bis ca. 447,5 nm emittiert und der andere LED-Chip im Bereich 455 nm - 462,5 nm, oder bei der ein Chip im Bereich von ca. 447,5 nm bis ca. 450 nm und der andere Chip im Bereich von ca. 457,5 nm bis ca. 462,5 nm emittiert.

Beide Kombinationen liefern einen Farbwertwiedergabeindex von größer 90, wobei die zuletzt genannte Kombination eine Abweichung bei 135°C bezüglich der MacAdam 2 Ellipse aufweist.

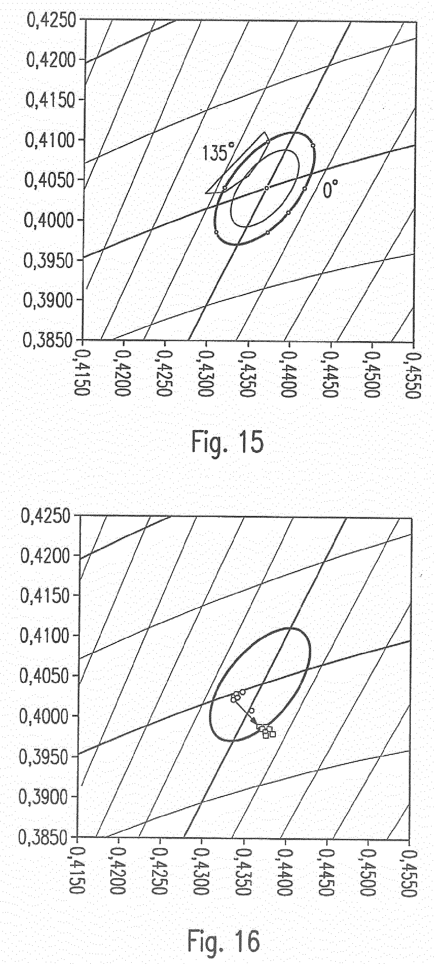

Eine Kombination der Wellenlänge von ca. 450 nm bis ca. 452,5 nm in Kombination mit einem LED-Chip mit dominanter Emissions-Wellenlänge von ca. 457,5 nm bis ca. 462 nm ist in Fig. 15 dargestellt, wobei diese Kombination im Bereich für blau gesättigte Farben Werte unter 90 aufweist.

Folglich kann also eine Kombination eines LED-Chips mit einer Wellenlänge im Bereich um ca. 445 nm bis ca. 447,5 nm kombiniert mit einem LED-Chip mit einer Wellenlänge im Bereich von ca. 457,5 nm bis ca. 462,5 nm gewählt werden, um stets einem Farbwertwiedergabeindex von größer 90 zu erhalten.

Ein Ausführungsbeispiel ist ein LED-Modul mit wenigstens einem LED-Chip mit einer Emissions-Wellenlänge im Bereich von ca. 447,5 nm bis ca. 450 nm und wenigstens einem LED-Chip mit einer Emissions-Wellenlänge im Bereich ca. 460 nm bis ca. 462,5 nm.

Dabei liegen in kaltem Zustand bei integraler Messung die gemessenen Werte innerhalb einer MacAdam 2 Ellipse wie es in Fig. 16 mit den hellgrauen Punkten dargestellt ist. Bei Betriebstemperatur, d.h., bei ca. 65°C verschieben sich die Farborte zum Rand der Ellipse. Dabei hat der Farbort des LED-Moduls nur eine geringe Abhängigkeit von dem Betriebsstrom des Weisslicht-LED-Modul. Die Abhängigkeit von der Betriebstemperatur ist dabei deutlicher.

Fig. 16 zeigt insbesondere, dass sich, solange das LED-Modul noch eine geringe Betriebstemperatur aufweist, sich der Farbort des LED-Modul-Lichts näher des Zentrums der MacAdam 2 Ellipse bewegt, als bei mit dunklen Rechtecken dargestellten Betrieb bei einer Betriebstemperatur von bspw. 65°C.

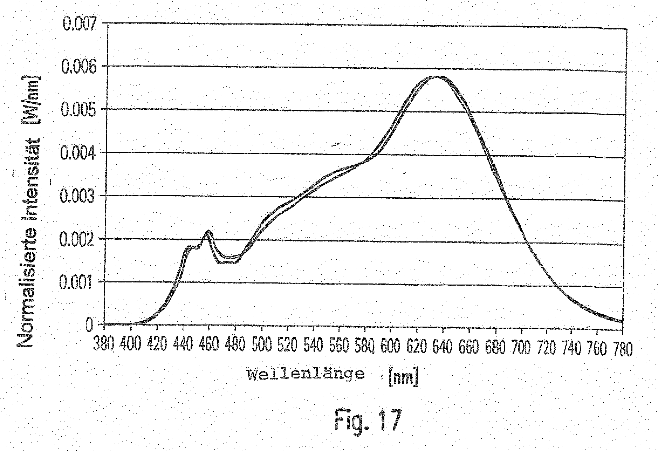

In Fig. 17 ist das Spektrum eines LED-Moduls dargestellt, woraus sich eine deutliche Unterscheidung bzgl. der Temperatur ergibt. Bei Einsatz von bspw. LuAG, der eine dominante Emissions-Wellenlänge im grünen Spektrum aufweist, ist dieser Effekt weniger deutlich, wobei der Peak im roten Bereich in Richtung des blauen Spektrums verschoben ist.

Dabei ist in Fig. 17 der Betrieb bei geringer Temperatur, in dem bspw. ein gepulster Betrieb der LED-Chips erfolgt, dunkelgrau dargestellt, während der Betrieb bei einer Betriebstemperatur von 65°C, bei der eine konstante Versorgung der LED-Chips erfolgt durch die graue Linie dargestellt ist.

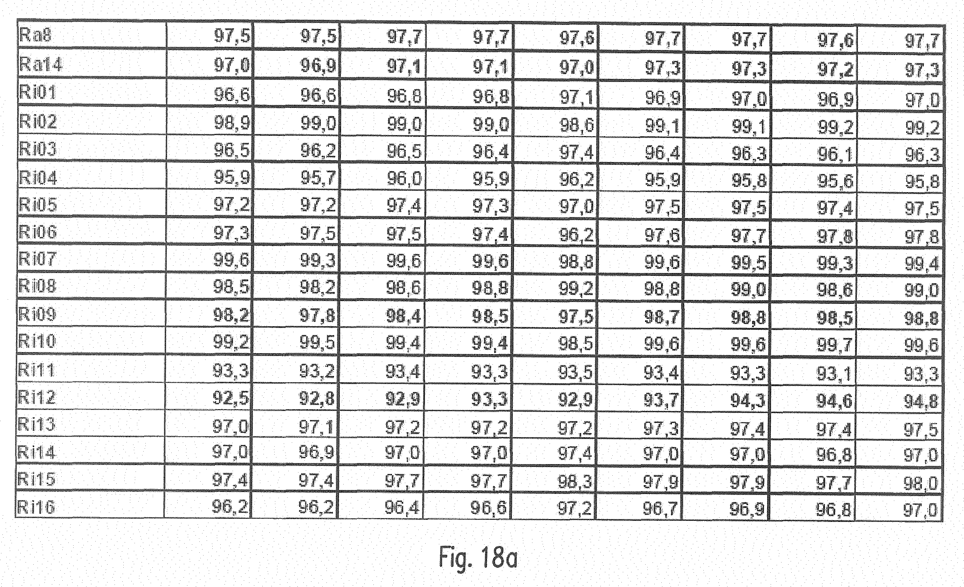

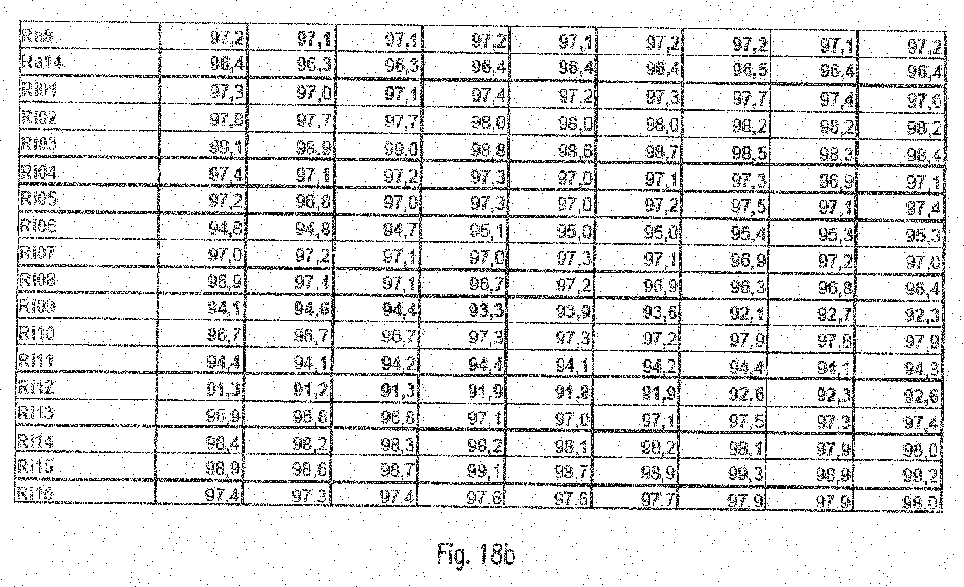

Fig. 18 zeigt Farbindexwerte für Betriebstemperaturen von 25°C (oben) und 65°C (unten).

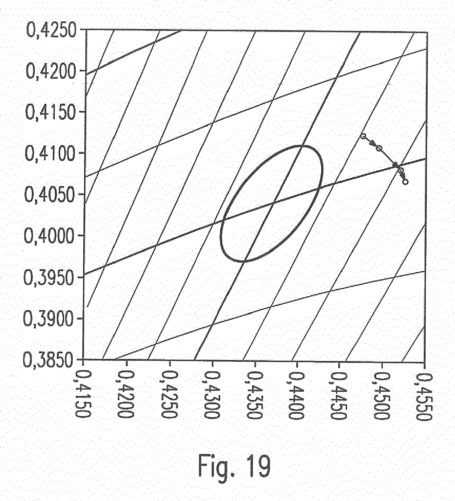

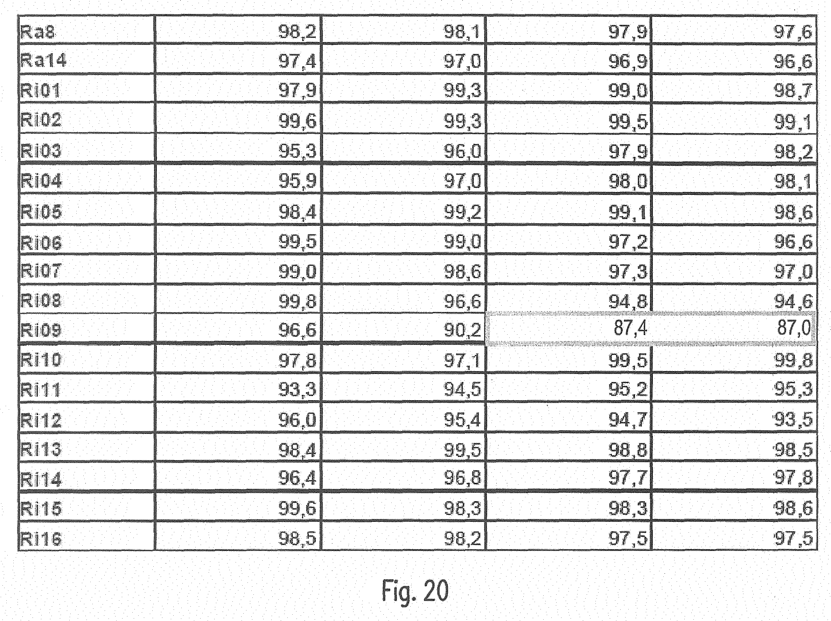

Eine Kombination von LED-Chips, z.B. mit einer Emissions-Wellenlänge von ca. 447, 5 nm bis ca. 450 nm und einer Emissions-Wellenlänge von ca. 457, 5 nm bis ca. 460 Nanometer, ist dabei nicht vorteilhaft, da sich das Farbspektrum des imitierten Lichts außerhalb des Toleranzbereichs nach MacAdam bewegt. Insbesondere kann beobachtet werden, dass die Teilfarbe "Rot gesättigt" in ihrem Farbwiedergabewert absinkt. Dies ist in den Figs. 19 und 20 veranschaulicht.

Bevorzugte Varianten sind indessen Kombinationen eines LED-Chips mit Emissions-Wellenlänge von ca. 447,5 nm bis ca. 450,0 nm und eines LED-Chips mit Emissions-Wellenlänge von ca. 460,0 nm bis ca. 462,5 nm, eines LED-Chips mit Emissions-Wellenlänge von ca. 450,0 nm bis ca. 452,5 nm und eines LED-Chips mit Emissions-Wellenlänge von ca. 457,5 nm bis ca. 460,0 nm, oder eines LED-Chips mit Emissions-Wellenlänge von ca. 450,0 nm bis ca. 452,5 nm und eines LED-Chips mit Emissions-Wellenlänge von ca. 460,0 nm bis ca. 462,5 nm.

Alle Varianten haben verschobene CIE Koordinaten, weisen allerdings bei 25°C einen Farbwiedergabeindex Rₐ>90 auf. Bei 65°C und bei 85°C ist in der 1. und der 2. bevorzugten Variante der Farbwiedergabewert bei "gesättigt Rot" unter 90 und bei der 3. bevorzugten Variante die von "gesättigt Blau" unter 90.

## Patentansprüche

1. Weisslicht-LED-Modul mit wenigstens einem LED-Chip,
wobei der LED-Chip Licht im blauen Spektrum im Bereich von 430 nm - 455 nm, insbesondere im Bereich von 445 nm - 450 nm, emittiert, wobei das LED-Modul weiterhin aufweist:
- ein erstes Farbkonversionsmaterial, vorzugsweise LuAG und insbesondere wenigstens ein grün emittierender Phosphor, das eine dominante Emissions-Wellenlänge im grünen Spektrum im Bereich von 500 nm - 575 nm aufweist,
- eine zweites Farbkonversionsmaterial, vorzugsweise ein Nitrid und insbesondere wenigstens ein rot emittierender Phosphor, das eine dominante Emissions-Wellenlänge im roten Spektrum im Bereich von 645 nm - 655 nm aufweist, insbesondere bei 650 nm.

2. Weisslicht-LED-Modul nach Anspruch 1, das weisses Licht mit einer Farbtemperatur von 3245K - 3255K, insbesondere 3250K emittiert.

3. Weisslicht-LED-Modul nach Anspruch 1 oder 2, wobei der Farbort des emittierten weissen Lichts im CIE-Normfarbsystem, insbesondere CIE 1931, durch die Werte x = ca. 0,4112 - ca. 0,4225 und y = ca. 0,3837 - ca. 0,3987 definiert ist und insbesondere der zentrale Farbort bei x=0,4177 und y=0,3918 liegt.

4. Weisslicht-LED-Modul nach einem der vorgehenden Ansprüche, wobei das emittierte weisse Licht einen Farbwiedergabeindex Rₐ von wenigstens 90 aufweist.

5. Weisslicht-LED-Modul nach einem der vorgehenden Ansprüche, wobei das Weisslicht-LED-Modul einen weiteren LED-Chip anderer Art aufweist, der Licht im blauen Spektrum, vorzugsweise im Bereich von 405 nm - 425 nm, insbesondere im Bereich von 410 nm - 420 nm emittiert.

6. Weisslicht-LED-Modul nach einem der vorgehenden Ansprüche, wobei der Anteil der LED-Chips anderer Art an der Gesamtanzahl der LED-Chips zwischen 5% und 30%, vorzugsweise 10% - 25% beträgt.

7. Weisslicht-LED-Modul nach einem der vorgehenden Ansprüche, wobei wenigstens eines der Farbkonversionsmaterialien in einem Dispens- oder Damm-and-Fill-Verfahren auf das Weisslicht-LED-Modul aufgebracht ist.

8. Weisslicht-LED-Modul nach einem der vorgehenden Ansprüche, wobei das Weisslicht-LED-Modul wenigstens ein weiteres Farbkonversionsmaterial aufweist, vorzugsweise ein Nitrid, das eine dominante Emissions-Wellenlänge im roten Spektrum aufweist, vorzugsweise im Bereich von 625 - 635 nm und insbesondere bei 630 nm.

9. Weisslicht-LED-Modul nach einem der vorgehenden Ansprüche, wobei die Farbkonversionsmaterialien jeweils zumindest teilweise auf den LED-Chips aufgebracht ist.

10. Weisslicht-LED-Modul nach einem der vorgehenden Ansprüche, wobei das erste Farbkonversionsmaterial besteht aus oder aufweist einem/ein Granatmaterial und/oder aus einer/eine Auswahl aus einer Gruppe von Granatmaterialien, aufweisend ein Cerium (Ce3+) dotiertes Lutetium, ein Cerium (Ce3+) dotiertes Yttrium oder ein Cerium (Ce3+) dotiertes Oxid, oder eine Kombination daraus.

11. Weisslicht-LED-Modul nach einem der vorgehenden Ansprüche, wobei das zweite Farbkonversionsmaterial besteht aus oder aufweist einer/eine Auswahl aus einer Gruppe von Europium (Eu2+) dotierten Nitriden oder Silikaten, insbesondere Oxy-Ortho-Silikaten, oder einer Kombination daraus.

12. Weisslicht-LED-Modul mit wenigstens zwei LED-Chips, wobei
- ein erster LED-Chip Licht im blauen Spektrum, in einem ersten Bereich von 430 nm - 455 nm emittiert, und
ein zweiter LED-Chip Licht im blauen Spektrum, in einem zweiten Bereich emittiert, und wobei
das LED-Modul weiterhin aufweist:
- ein erstes Farbkonversionsmaterial, vorzugsweise LuAG und insbesondere wenigstens ein grün emittierender Phosphor, das eine dominante Emissions-Wellenlänge im grünen Spektrum im Bereich von 500 nm - 575 nm aufweist,
- eine zweites Farbkonversionsmaterial, vorzugsweise ein Nitrid und insbesondere wenigstens ein rot emittierender Phosphor, das eine dominante Emissions-Wellenlänge im roten Spektrum im Bereich 645 nm - 655 nm aufweist, insbesondere bei 650 nm.

13. Weisslicht-LED-Modul nach Anspruch 12, wobei der erste und der zweite Bereich disjunkt sind.

14. Weisslicht-LED-Modul nach Anspruch 12 oder 13, wobei der erste Bereich Wellenlängen von 440 nm - 455 nm, insbesondere von 445 nm - 447,5 nm aufweist, und der zweite Bereich Wellenlängen von 450 nm - 465 nm, insbesondere von 457,5 nm - 462,5 nm aufweist.

15. Weisslicht-LED-Modul nach einem der Ansprüche 12 - 14, wobei der erste Bereich Wellenlängen von 447,5 nm - 450,0 nm aufweist.

16. Weisslicht-LED-Modul nach einem der Ansprüche 12 - 15, wobei der erste Bereich Wellenlängen von 440 nm - 455 nm, insbesondere von 447,5 nm - 450 nm aufweist, und der zweite Bereich Wellenlängen von 450 nm - 465 nm, insbesondere von 457,5 nm - 460 nm aufweist.

17. Weisslicht-LED-Modul nach einem der Ansprüche 12 - 16, wobei der erste Bereich Wellenlängen von 440 nm - 455 nm, insbesondere von 447,5 nm - 450 nm aufweist, und der zweite Bereich Wellenlängen von 455 nm - 465 nm, insbesondere von 460 nm - 462,5 nm aufweist.

18. Weisslicht-LED-Modul nach einem der Ansprüche 12 - 17, wobei der erste Bereich Wellenlängen von 445 nm - 455 nm, insbesondere von 450 nm - 452,5 nm aufweist, und der zweite Bereich Wellenlängen von 455 nm - 465 nm, insbesondere von 457,5 nm - 460 nm aufweist.

19. Weisslicht-LED-Modul nach einem der Ansprüche 12 - 18, wobei der erste Bereich Wellenlängen von 445 nm - 455 nm, insbesondere von 450 nm - 452,5 nm aufweist, und der zweite Bereich Wellenlängen von 455 nm - 465 nm, insbesondere von 460 nm - 462,5 nm aufweist.

20. Weisslicht-LED-Modul nach einem der Ansprüche 12 - 19, wobei wenigstens ein LED-Chip kein Farbkonversionsmaterial aufweist, das eine dominante Emissions-Wellenlänge vorzugsweise im Bereich von 625 nm - 635 nm und insbesondere bei 630 nm aufweist.

21. Weisslicht-LED-Modul nach einem der Ansprüche 12 - 20, wobei das emittierte weisse Licht durch eine Chromatizität aufweist, die in einer MacAdam Ellipse um den zentralen Farbort liegt, insbesondere einer MacAdam3 Ellipse und vorzugsweise eine 3SDCM Homogenität aufweist.

22. Weisslicht-LED-Modul nach einem der Ansprüche 12 - 21, wobei das erste Farbkonversionsmaterial besteht aus oder aufweist einem/ein Granatmaterial und/oder aus einer/eine Auswahl aus einer Gruppe von Granatmaterialien, aufweisend ein Cerium (Ce3+) dotiertes Lutetium, ein Cerium (Ce3+) dotiertes Yttrium oder ein Cerium (Ce3+) dotiertes Oxid, oder eine Kombination daraus.

23. Weisslicht-LED-Modul nach einem der Ansprüche 12 - 22, wobei das zweite Farbkonversionsmaterial besteht aus oder aufweist einer/eine Auswahl aus einer Gruppe von Europium (Eu2+) dotierten Nitriden oder Silikaten, insbesondere Oxy-Ortho-Silikaten, oder einer Kombination daraus.

## Claims

1. White light LED module having at least one LED chip,
wherein the LED chip emits light in the blue spectrum in the range of 430 nm - 455 nm, in particular in the range of 445 nm - 450 nm, wherein the LED module further has:
- a first color conversion material, preferably LuAg, and in particular at least one green-emitting phosphor having a dominant emission wavelength in the green spectrum in the range of 500 nm - 575 nm,
- a second color conversion material, preferably a nitride, and in particular at least one red-emitting phosphor having a dominant emission wavelength in the red spectrum in the range of 645 nm - 655 nm, in particular at 650 nm.

2. White light LED module according to Claim 1, which emits white light having a color temperature of 3245K - 3255K, in particular 3250K.

3. White light LED module according to Claim 1 or 2, wherein the color point of the emitted white light is defined in the CIE standard color system, in particular CIE 1931, by the values x = approx. 0.4112 - approx. 0.4225 and y = approx. 0.3837- approx. 0.3987, and the central color point is in particular at x = 0.4177 and y = 0.3918.

4. White light LED module according to any one of the preceding Claims, wherein the emitted white light has a color rendering index Ra of at least 90.

5. White light LED module according to any one of the preceding Claims, wherein the white light LED module has a further LED chip of a different type, which emits light in the blue spectrum, preferably in the range of 405 nm - 425 nm, in particular in the range of 410 nm - 420 nm.

6. White light LED module according to any one of the preceding Claims, wherein the proportion of LED chips of a different type in the total number of LED chips is between 5% and 30%, preferably 10%-25%.

7. White light LED module according to any one of the preceding Claims, wherein at least one of the color conversion materials is applied to the white light LED module using a dispensing or dam and fill technique.

8. White light LED module according to any one of the preceding Claims, wherein the white light LED module has at least one further color conversion material, preferably a nitride, having a dominant emission wavelength in the red spectrum, preferably in the range of 625 - 635 nm and in particular 630 nm.

9. White light LED module according to any one of the preceding Claims, wherein the color conversion materials are in each case at least partially applied to the LED chip.

10. White light LED module according to any one of the preceding Claims, wherein the first color conversion material consists of or has a garnet material and/or a selection from a group of garnet materials having a cerium (Ce3+)-doped lutetium, a cerium (Ce3+)-doped yttrium or a cerium (Ce3+)-doped oxide, or a combination thereof.

11. White light LED module according to any one of the preceding Claims, wherein the second color conversion material consists of or has a selection from a group of europium (Eu2+)-doped nitrides or silicates, in particular oxyorthosilicates, or a combination thereof.

12. White light LED module having at least two LED chips,
wherein
- a first LED chip emits light in the blue spectrum, in a first range of 430 nm - 455 nm, and
- a second LED chip emits light in the blue spectrum, in a second range, and wherein
the LED module further has:
- a first color conversion material, preferably LuAg, and in particular at least one green-emitting phosphor having a dominant emission wavelength in the green spectrum in the range of 500 nm - 575 nm,
- a second color conversion material, preferably a nitride, and in particular at least one red-emitting phosphor having a dominant emission wavelength in the red spectrum in the range of 645 nm - 655 nm, in particular at 650 nm.

13. White light LED module according to Claim 12, wherein the first and the second region are disjunct.

14. White light LED module according to Claim 12 or 13, wherein the first region has wavelengths of 440 nm - 455 nm, in particular 445 nm - 447.5 nm, and the second region has wavelengths of 450 nm - 465 nm, in particular 457.5 nm - 462.5 nm.

15. White light LED module according to any one of Claims 12 - 14, wherein the first region has wavelengths of 447.5 nm - 450.0 nm.

16. White light LED module according to any one of Claims 12 - 15, wherein the first region has wavelengths of 440 nm - 455 nm, in particular 447.5 nm - 450 nm, and the second region has wavelengths of 450 nm - 465 nm, in particular 457.5 nm - 460 nm.

17. White light LED module according to any one of Claims 12 - 16, wherein the first region has wavelengths of 440 nm - 455 nm, in particular 447.5 nm - 450 nm, and the second region has wavelengths of 455 nm - 465 nm, in particular 460 nm - 462.5 nm.

18. White light LED module according to any one of Claims 12 - 17, wherein the first region has wavelengths of 445 nm - 455 nm, in particular 450 nm - 452.5 nm, and the second region has wavelengths of 455 nm - 465 nm, in particular 457.5 nm - 460 nm.

19. White light LED module according to any one of Claims 12 - 18, wherein the first region has wavelengths of 445 nm - 455 nm, in particular 450 nm - 452.5 nm, and the second region has wavelengths of 455 nm - 465 nm, in particular 460 nm - 462.5 nm.

20. White light LED module according to any one of Claims 12 - 19, wherein at least one LED chip has no color conversion material having a dominant emission wavelength preferably in the range of 625 - 635 nm and in particular 630 nm.

21. White light LED module according to any one of Claims 12 - 20, wherein the emitted white light has a chromaticity lying within a MacAdam ellipse around the central color point, in particular a 3-step MacAdam ellipse, and preferably has a 3 SDCM homogeneity.

22. White light LED module according to any one of Claims 12 - 21, wherein the first color conversion material consists of or has a garnet material and/or a selection from a group of garnet materials having a cerium (Ce3+)-doped lutetium, a cerium (Ce3+)-doped yttrium or a cerium (Ce3+)-doped oxide, or a combination thereof.

23. White light LED module according to any one of Claims 12 - 22, wherein the second color conversion material consists of or has a selection from a group of europium (Eu2+)-doped nitrides or silicates, in particular oxyorthosilicates, or a combination thereof.

## Revendications

1. Module de LED de lumière blanche comprenant au moins une puce à LED,
la puce à LED émettant de la lumière dans le spectre bleu dans la plage de 430 nm à 455 nm, en particulier dans la plage de 445 nm à 450 nm, le module de LED comprenant en outre :
- un premier matériau de conversion de couleur, de préférence du LuAG et en particulier au moins un phosphore émettant dans le vert, qui présente une longueur d'onde d'émission dominante dans le spectre vert dans la plage de 500 nm à 575 nm,
- un deuxième matériau de conversion de couleur, de préférence un nitrure et en particulier au moins un phosphore émettant dans le rouge, qui présente une longueur d'onde d'émission dominante dans le spectre rouge dans la plage de 645 nm à 655 nm, en particulier autour de 650 nm.

2. Module de LED de lumière blanche selon la revendication 1, qui émet de la lumière blanche avec une température de couleur de 3245 K à 3255 K, en particulier de 3250 K.

3. Module de LED de lumière blanche selon la revendication 1 ou 2, les coordonnées de chromaticité de la lumière blanche dans l'espace de couleur CIE, en particulier dans le CIE 1931, étant définies par les valeurs x = env. 0,4112 à env. 0,4225 et y = env. 0,3837 à env. 0,3987 et en particulier les coordonnées de chromaticité centrales étant de x=0,4177 et y=0,3918.

4. Module de LED de lumière blanche selon l'une quelconque des revendications précédentes, la lumière blanche émise présentant un indice de rendu de couleurs Ra d'au moins 90.

5. Module de LED de lumière blanche selon l'une quelconque des revendications précédentes, le module de LED de lumière blanche comprenant une autre puce à LED d'un autre type, qui émet de la lumière dans le spectre bleu de préférence dans la plage de 405 nm à 425 nm, en particulier dans la plage de 410 nm à 420 nm.

6. Module de LED de lumière blanche selon l'une quelconque des revendications précédentes, la part de la puce à LED d'un autre type au nombre total des puces à LED étant entre 5 % et 3 0%, de préférence entre 10 % et 25 %.

7. Module de LED de lumière blanche selon l'une quelconque des revendications précédentes, au moins un des matériaux de conversion de couleur étant appliqué sur le module de LED de lumière blanche par un processus de distribution ou de barrage et remplissage.

8. Module de LED de lumière blanche selon l'une quelconque des revendications précédentes, le module de LED de lumière blanche comprenant au moins un autre matériau de conversion de couleur, de préférence un nitrure, qui présente une longueur d'onde d'émission dominante dans le spectre rouge, de préférence dans la plage de 625 à 635 nm et en particulier autour de 630 nm.

9. Module de LED de lumière blanche selon l'une quelconque des revendications précédentes, les matériaux de conversion de couleur étant appliqués respectivement au moins partiellement sur les puces à LED.

10. Module de LED de lumière blanche selon l'une quelconque des revendications précédentes, le premier matériau de conversion de couleur étant composé de ou comprenant un matériau en grenat et/ou une sélection d'un groupe de matériaux en grenat, comprenant un lutécium dopé avec du cérium (Ce3+), un yttrium dopé avec du cérium (Ce3+) ou un oxyde dopé avec du cérium (Ce3+) ou une combinaison de ceux-ci.

11. Module de LED de lumière blanche selon l'une quelconque des revendications précédentes, le deuxième matériau de conversion de couleur tant composé de ou comprenant une sélection d'un groupe de nitrures ou des silicates dopés avec de l'europium (Eu2+), ou une combinaison de ceux-ci.

12. Module de LED de lumière blanche comprenant au moins deux puces à LED,
- une première puce à LED émettant de la lumière dans le spectre bleu, dans une première plage de 430 nm à 455 nm, et
- une deuxième puce à LED émettant de la lumière dans le spectre bleu, dans une deuxième plage, et
le module de LED comprenant en outre :
- un premier matériau de conversion de couleur, de préférence du LuAG et en particulier au moins un phosphore émettant dans le vert, qui présente une longueur d'onde d'émission dominante dans le spectre vert dans la plage de 500 nm à 575 nm,
- un deuxième matériau de conversion de couleur, de préférence un nitrure et en particulier au moins un phosphore émettant dans le rouge, qui présente une longueur d'onde d'émission dominante dans le spectre rouge dans la plage de 645 nm à 655 nm, en particulier autour de 650 nm.

13. Module de LED de lumière blanche selon la revendication 12, la première plage et la deuxième plage étant disjointes.

14. Module de LED de lumière blanche selon la revendication 12 ou 13, la première plage comprenant des longueurs d'onde de 440 nm à 455 nm, en particulier de 445 nm à 447,5 nm, et la deuxième plage comprenant des longueurs d'onde de 450 nm à 465 nm, en particulier de 457,5 nm à 462,5 nm.

15. Module de LED de lumière blanche selon l'une quelconque des revendications 12 à 14, la première plage comprenant des longueurs d'onde de 447,5 nm à 450,0 nm.

16. Module de LED de lumière blanche selon l'une quelconque des revendications 12 à 15, la première plage comprenant des longueurs d'onde de 440 nm à 455 nm, en particulier de 447,5 nm à 450 nm, et la deuxième plage comprenant des longueurs d'onde de 450 nm à 465 nm, en particulier de 457,5 nm à 460 nm.

17. Module de LED de lumière blanche selon l'une quelconque des revendications 12 à 16, la première plage comprenant des longueurs d'onde de 440 nm à 455 nm, en particulier de 447,5 nm à 450 nm, et la deuxième plage comprenant des longueurs d'onde de 455 nm à 465 nm, en particulier de 460 nm à 462,5 nm.

18. Module de LED de lumière blanche selon l'une quelconque des revendications 12 à 17, la première plage comprenant des longueurs d'onde de 445 nm à 455 nm, en particulier de 450 nm à 452,5 nm, et la deuxième plage comprenant des longueurs d'onde de 455 nm à 465 nm, en particulier de 457,5 nm à 460 nm.

19. Module de LED de lumière blanche selon l'une quelconque des revendications 12 à 18, la première plage comprenant des longueurs d'onde de 445 nm à 455 nm, en particulier de 450 nm à 452,5 nm, et la deuxième plage comprenant des longueurs d'onde de 455 nm à 465 nm, en particulier de 460 nm à 462,5 nm.

20. Module de LED de lumière blanche selon l'une quelconque des revendications 12 à 19, au moins une des puces à LED ne comprenant pas de matériau de conversion de couleur qui présente une longueur d'onde d'émission dominante dans la plage de 625 nm à 635 nm et en particulier autour de 630 nm.

21. Module de LED de lumière blanche selon l'une quelconque des revendications 12 à 20, la lumière blanche émise présentant une chromaticité qui s'étend en une ellipse de MacAdam autour des coordonnées de chromaticité centrales, en particulier une ellipse de MacAdam3 et présentant de préférence une homogénéité 3SDCM.

22. Module de LED de lumière blanche selon l'une quelconque des revendications 12 à 21, le premier matériau de conversion de couleur étant composé de ou comprenant un matériau en grenat et/ou une sélection d'un groupe de matériaux en grenat, comprenant un lutécium dopé avec du cérium (Ce3+), un yttrium dopé avec du cérium (Ce3+) ou un oxyde dopé avec du cérium (Ce3+) ou une combinaison de ceux-ci.

23. Module de LED de lumière blanche selon l'une quelconque des revendications 12 à 22, le deuxième matériau de conversion de couleur tant composé de ou comprenant une sélection d'un groupe de nitrures ou des silicates dopés avec de l'europium (Eu2+), ou une combinaison de ceux-ci.
